# EUROPEAN PATENT APPLICATION

(11) **EP 4 571 930 A1**
(43) Date of publication of application: **18.06.2025**
(21) Application number: 24203849.5
(22) Date of filing: 01.10.2024
(51) Int. Cl.: H01M 10/42, H01M 10/658, H01M 50/298, H01M 50/569, A62C 3/00, B60L 3/00, H01M 10/48, H01M 10/633

(54) **BATTERY PACK, THERMAL RUNAWAY EARLY WARNING CONTROL METHOD FOR BATTERY PACK, AND RELATED DEVICE**

(30) Priority: 13.12.2023 CN 202311715942; 22.05.2024 WO PCT/CN2024/094705
(71) Applicant: Eve Energy Storage Co., Ltd, Wuhan, Hubei 430074 (CN)
(72) Inventor: FAN, Shilin, Wuhan, Hubei, 430074 (CN); DING, Hongtao, Wuhan, Hubei, 430074 (CN); FENG, Chaojun, Wuhan, Hubei, 430074 (CN)
(74) Representative: Murgitroyd & Company

(57) **Abstract**

The present application provides a battery pack, a thermal runaway early warning control method for the battery pack, and a related device. The battery pack includes: a plurality of electric cells, a BMS slave board, a BMS master board, a high-temperature detection module, and a fire extinguishing module. The BMS slave board collects battery data of the battery, the high-temperature detection module collects temperature data of the battery, and the BMS master control sends an early warning signal or performs the fire extinguishing control processing on the battery through the fire extinguishing module.

## Description

### TECHNICAL FIELD

The present application relates to a technical field of batteries, and more particularly, to a battery pack, a thermal runaway early warning control method for a battery pack, and related device.

### BACKGROUND

Generally, with increasing application fields of new energy battery systems such as ships, energy storage vehicles, and commercial vehicles, the safety of the battery system itself is the focus of increasing attention. In the process of use, a thermal runaway phenomenon and a thermal diffusion phenomenon may occur. However, at present, for the thermal runaway for the battery pack, a monitoring and alarming processing is performed mainly after the thermal runaway phenomenon has occurred in the battery pack.

### TECHNICAL PROBLEM

However, in such a manner that the monitoring and alarming processing is performed after the thermal runaway phenomenon has occurred in the battery pack, the corresponding diffusion prevention processing may not be performed.

### TECHNICAL SOLUTION

According to a first aspect, some embodiments of the present application provides a battery pack including a plurality of batteries, a battery management system (BMS) slave board, a BMS master board, a high-temperature detection module, and a fire extinguishing module, wherein the BMS slave board, the high-temperature detection module, and the fire extinguishing module are respectively communicatively connected to the BMS master board.
the BMS slave board is communicatively connected to each of the plurality of batteries, and is configured to collect battery data corresponding to each of the plurality of batteries and send the battery data to the BMS master board;
the high-temperature detection module is connected to each of the plurality of batteries and is configured to collect temperature data corresponding to each of the plurality of batteries and send the temperature data to the BMS master board; and
the fire extinguishing module is configured to prevent thermal diffusion from occurring in the battery in response to a start instruction sent by the BMS master board.

According to a second aspect, some embodiments of the present application provide a thermal runaway early warning control method for a battery pack, where the thermal runaway early warning control method for the battery pack is applied to the battery pack according to the first aspect, and the battery pack includes a plurality of batteries. The thermal runaway early warning control method for the battery pack includes:
obtaining battery data corresponding to each of the plurality of batteries;
obtaining temperature data corresponding to each of the plurality of batteries;
determining a risk level of thermal runaway for each of the plurality of batteries according to the battery data and/or the temperature data;
if it is detected that the risk level is less than a preset thermal diffusion level, sending an early warning signal corresponding to the risk level; and
if it is detected that the risk level is greater than or equal to the preset thermal diffusion level, performing a fire extinguishing control processing on one of the plurality of batteries with the risk level greater than or equal to the preset thermal diffusion level to prevent the thermal diffusion from occurring.

According to a third aspect, some embodiments of the present application provides a thermal runaway early warning control device of a battery pack, where the thermal runaway early warning control device for the battery pack is applied to the battery pack according to the first aspect. The thermal runaway early warning control device for the battery pack includes:
a first obtaining module, configured to obtain battery data corresponding to each of the plurality of batteries;
a second obtaining module, configured to obtain temperature data corresponding to each of the plurality of batteries;
a determining module, configured to determine a risk level of thermal runaway of each of the plurality of batteries according to the battery data and/or the temperature data;
an early warning module, configured to, if it is detected that the risk level is less than the preset thermal diffusion level, send an early warning signal corresponding to the risk level; and
a control module, configured to, if it is detected that the risk level is greater than or equal to the preset thermal diffusion level, perform a fire extinguishing control processing on one of the plurality of batteries with the risk level greater than or equal to the preset thermal diffusion level, to prevent the thermal diffusion from occurring.

According to a fourth aspect, some embodiments of the present application provide an electronic device including:
one or more processors;
a memory; and
one or more applications, wherein the one or more applications are stored in a memory and configured to be executed by a processor to implement the steps in the thermal runaway early warning control method for the battery pack according to the second aspect.

According to a fifth aspect, some embodiments of the present application further provide a computer readable storage medium having stored thereon a computer program loaded by a processor to perform the steps in the thermal runaway early warning control method for the battery pack according to the second aspect.

### BENEFICIAL EFFECT

In some embodiments of the present application, the battery data corresponding to each battery is collected through the BMS slave board, and the battery data is transmitted to the BMS master board. The temperature data corresponding to each battery is collected through the high-temperature detection module, and the temperature data is transmitted to the BMS master board. The BMS master board determines a risk level of thermal runaway for each battery according to the battery data and/or the temperature data, sends an early warning signal corresponding to the risk level when the risk level is less than a preset thermal diffusion level, and sends a start instruction to the fire extinguishing module when the risk level is greater than or equal to the preset thermal diffusion level. The fire extinguishing module starts a fire extinguishing function to perform fire extinguishing control processing on the battery with the risk level greater than or equal to the preset thermal diffusion level, to prevent the thermal diffusion from occurring. A comprehensive and accurate judgment of the thermal runaway for the battery in the battery pack is realized, under the condition that the thermal diffusion condition is not satisfied, an early warning corresponding to the risk level of the battery is performed, and under the condition that the thermal diffusion condition is satisfied, a fire extinguishing process on the battery is performed in time, so that the thermal diffusion of the battery in the battery pack may be effectively suppressed and the safety performance of the battery pack may be improved.

### BRIEF DESCRIPTION OF THE DRAWINGS

FIG. 1 is a schematic block diagram of a battery pack according to some embodiments of the present application;
FIG. 2 is a schematic block diagram of a battery pack according to another some embodiments of the present application;
FIG. 3 is a schematic flowchart of a thermal runaway early warning control method for a battery pack according to some embodiments of the present application;
FIG. 4 is a schematic block diagram of a thermal runaway early warning control device for a battery pack according to some embodiments of the present application; and
FIG. 5 is a schematic block diagram of an electronic device according to some embodiments of the present application.

### DETAILED DESCRIPTION OF EMBODIMENTS

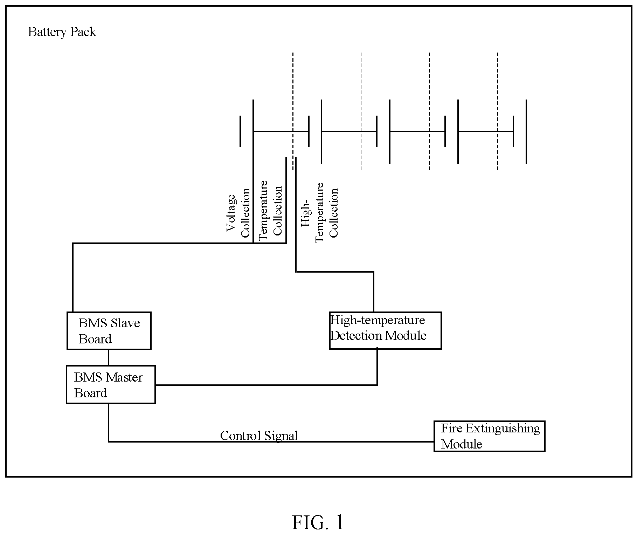

FIG. 1 is a schematic block diagram of a battery pack according to some embodiments of the present application. The battery pack includes a plurality of batteries, a battery management system (BMS) slave board, a BMS master board, a high-temperature detection module, and a fire extinguishing module. The BMS slave board, the high-temperature detection module, and the fire extinguishing module are communicatively connected to the BMS master board.

At least two batteries are distributed within the battery pack. Both of the BMS slave board and the BMS master board are management modules in a BMS battery management system. In the present embodiment, the BMS slave board is configured to collect data and transmit the data to the BMS master board, and the BMS master board is configured to analyze the collected data. The BMS slave board, the high-temperature detection module, and the fire extinguishing module are respectively communicatively connected to the BMS master board.

The BMS slave board is communicatively connected to the respective batteries, and is configured to collect battery data of each battery, and transmit the battery data to the BMS master board.

In some embodiments, the BMS slave board is configured to collect the battery data, such as the voltage, the temperature, the temperature rise, or the like, corresponding to each battery and transmit the battery data to the BMS master board, so that the BMS master board performs thermal runaway detection on respective batteries based on the collected battery data.

The high-temperature detection module is connected to each battery and is configured to collect temperature data corresponding to each battery and send the temperature data to the BMS master board.

The high-temperature detection module may be connected to the respective batteries by welding or by adhesive. The high-temperature detection module may be a temperature sensor or a negative temperature coefficient (NTC), which is configured to collect the temperature data of each battery in real time and send the temperature data to the BMS master board so that the BMS master board performs the thermal runaway detection on each battery based on the collected temperature data.

The BMS master board is configured to determine a risk level of thermal runaway of each battery according to the received battery data and/or the received temperature data, send an early warning signal corresponding to the risk level when the risk level is less than a preset thermal diffusion level, and send a start instruction to the fire extinguishing module when the risk level is greater than or equal to the preset thermal diffusion level.

The risk level is a level for representing the risk of the thermal runaway of the battery, and the preset thermal diffusion level is a level at which the thermal runaway of the battery occurs. For example, the risk level may be a first level, a second level, a third level, a fourth level, or the like. The first level represents that the temperature of the battery is relatively higher, the second level represents that the temperature of the battery is too high, and the third level represents the thermal runaway of the battery. The fourth level represents the thermal diffusion, and the preset thermal diffusion level may be the third level.

In some embodiments, the BMS master board may perform analysis according to the battery data and a data threshold value corresponding to the preset thermal runaway level, may perform analysis according to the temperature data and the data threshold value corresponding to the preset thermal runaway level, or may perform analysis according to the battery data and the temperature data based on the data threshold value corresponding to the preset thermal runaway level, to determine the risk level of thermal runaway for each battery. When the risk level is less than the preset thermal diffusion level, it represents that the probability of thermal runaway for the battery pack is lower, and the BMS master board may output the early warning information corresponding to the risk level. For example, when the risk level is the first level, a first-level early warning instruction is issued. When the risk level is greater than or equal to the preset thermal diffusion level, it represents that thermal runaway and thermal diffusion may occur in the battery pack. Therefore, the BMS master board sends a start instruction to the fire extinguishing module to suppress thermal diffusion for the battery and protect the battery pack.

The fire extinguishing module is configured to prevent the thermal diffusion from occurring in the battery in response to the start command sent by the BMS master board.

The fire extinguishing module may be an aerosol system, and the fire extinguishing treatment is performed on the battery or the battery pack subjected to the thermal runaway by ejecting the aerosol.

In some embodiment, when the fire extinguishing module receives the start instruction sent by the BMS master module, the fire extinguishing module starts the fire extinguishing function thereof to perform fire extinguishing control processing on the battery with the risk level greater than or equal to the preset thermal diffusion level, to prevent the thermal diffusion from occurring in the battery in the battery pack.

For the battery pack in some embodiment of the present application, a comprehensive and accurate judgment of the thermal runaway for the battery in the battery pack is realized, under the condition that the thermal diffusion condition is not satisfied, an early warning corresponding to the risk level of the battery is performed, and under the condition that the thermal diffusion condition is satisfied, a fire extinguishing process on the battery is performed in time, so that the thermal diffusion of the battery in the battery pack may be effectively suppressed and the safety performance of the battery pack may be improved.

Each battery is provided with a signal point, and a corresponding one of signal lines is led from each signal point. The BMS slave board is connected to the signal line through a wire harness, and is configured to collect the battery data of the battery.

In some embodiments, each battery is configured with a signal point, and a signal line is led from the signal point. The BMS slave board is connected to the signal line through the wire harness, so that the battery signal is transmitted to the BMS slave board through the signal line, thereby realizing the collection of the battery signal, such as the voltage, the temperature, and/or the like, that is, the collection of the battery data corresponding to each signal point. The position information of the signal point and the battery data are sent to the BMS master board so that the BMS master board may distinguish the respective batteries, thereby accurately positioning the battery.

The high-temperature detection module is connected to the signal line through the wire harness, and is configured to collect temperature data of the corresponding battery.

In some embodiments, the high-temperature detection module is connected to the signal line through the wire harness, so that the battery signal is transmitted to the high-temperature detection module through the signal line, thereby collecting the temperature data in the battery signal, that is, collecting the temperature data corresponding to each signal point, and transmitting the signal point and the corresponding battery data to the BMS master board so that the BMS master board may distinguish the respective batteries, thereby accurately positioning the battery.

Note that the battery data includes a battery temperature. The BMS master board is further configured to check the battery temperature and the temperature data of the battery to obtain a temperature check result, and determine the risk level of thermal runaway for each battery according to the temperature check result and the battery data. The temperature check result is used to represent whether the battery temperature collected by the BMS slave board is similar with the temperature data collected by the high-temperature detection module, and the temperature check result includes two cases in which the temperatures are similar with each other and the temperatures differ greatly. Specifically, the BMS master board checks the battery temperature and the temperature data to obtain the temperature check result. When the temperature check result represents that the temperatures are similar with each other, it indicates that the battery temperature and temperature data are accurate. When the temperature check result represents that the temperature difference is relatively greater, it is possible to determine the risk level of the thermal runaway for each battery according to the battery data. In the present embodiment, the temperature data collected in real time by the high-temperature detection module and the battery temperature in the battery data collected by the BMS slave board are checked, so that misjudgment of the collected data is avoided, the accuracy of the collected data is ensured, and the accuracy of the thermal runaway detection for the battery is further improved.

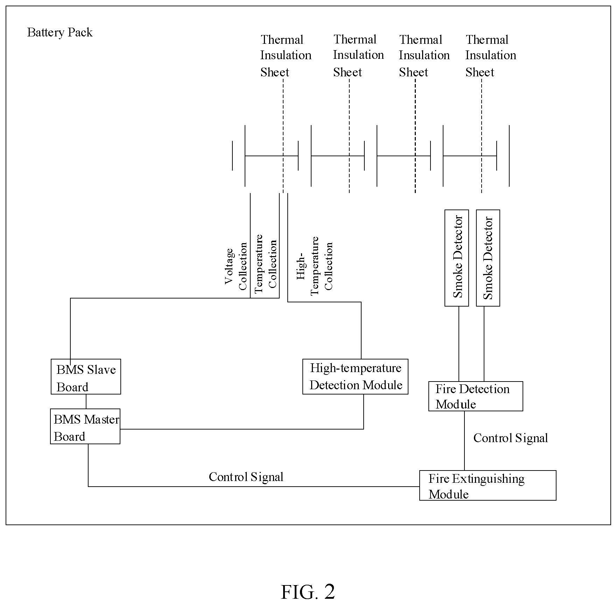

As shown in FIG. 2, FIG. 2 is a schematic block diagram of another battery pack. The battery pack further includes a fire detection module, which is communicatively connected to the fire extinguishing module. The fire detection module includes at least one of a smoke detector, a smoke detector, and a temperature sensor. The fire detection module is configured to drive the fire extinguishing module to perform a fire extinguishing function to prevent the battery pack from igniting and exploding.

In some embodiments, the fire detection module includes the smoke detector, the smoke detector, and the temperature sensor. The fire detection module collects at least one of the smoke amount, the temperature data, and the gas concentration for the battery pack, and when any one of the smoke amount, the temperature data, and the gas concentration is detected to be abnormal, the fire extinguishing module is driven to perform a fire extinguishing function to prevent the battery pack from igniting and exploding, and further effectively suppresses the thermal diffusion for the battery pack. In case of failure of the BMS slave board, the BMS master board, and the high-temperature detection module, the fire detection module may further timely detect and effectively suppress the thermal runaway and the thermal diffusion for the battery pack, thereby providing a dual guarantee for the battery pack, and further improving the safety performance of the battery pack.

The battery pack further includes a thermal insulation sheet disposed between two adjacent batteries.

In some embodiments, the thermal insulation sheet is additionally added between battery levels in the battery pack, to avoid thermal diffusion to other batteries when the thermal runaway occurs, thereby protecting batteries that are not subjected to the thermal runaway. It may be understood that in the present embodiment, by providing the thermal insulation sheet between two adjacent batteries, it is possible not only to avoid the thermal runaway spreading to other batteries, but also to prevent the batteries with the thermal runaway from affecting the other batteries after the fire extinguishing module and the fire detection module are failed at the same time, thereby avoiding thermal runaway diffusion for the battery pack and providing further guarantee for the treatment of the control of the thermal runaway for the battery pack.

The battery pack further includes a main circuit power-on control module, the main circuit power-on control module is communicatively connected to the BMS master board.

In some embodiments, the battery pack further includes a main circuit power-on control module, which is communicatively connected with the BMS master board and is configured to control power-on of the main circuit of the battery pack, including enabling the power-on and disabling the power-on. When the BMS master board detects that the risk level is greater than or equal to the preset thermal diffusion level, it indicates the possibility of the thermal diffusion for the battery pack. Therefore, the BMS master board sends a power-on prohibition command to the main circuit power-on control module of the battery pack to control the battery pack to stop charging and discharging, thereby realizing the judgment of the thermal runaway of the battery pack in advance, and further ensuring the safety performance of the battery pack.

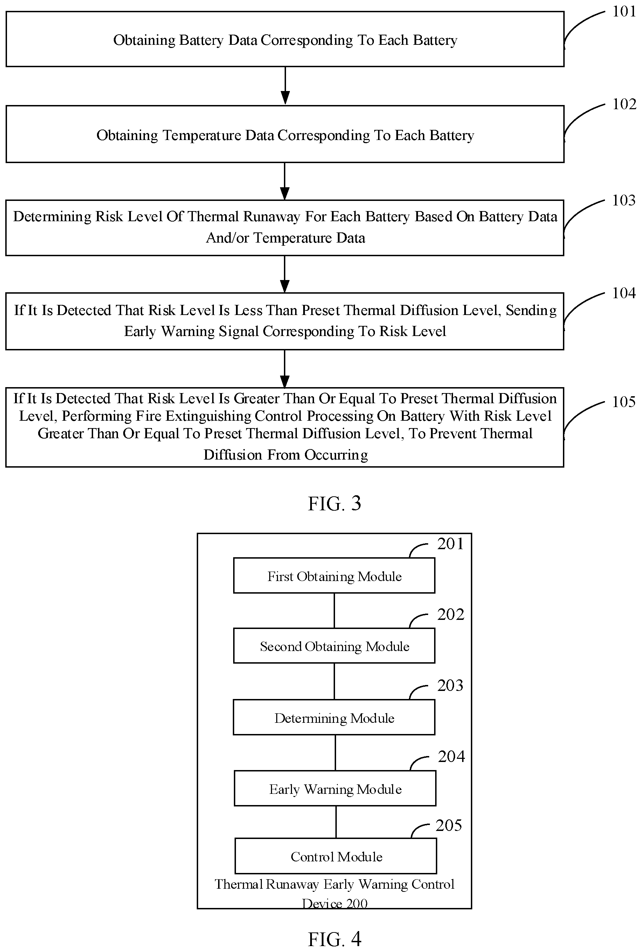

As shown in FIG. 3, some embodiments of the present application further provide a thermal runaway early warning control method of a battery pack including a plurality of batteries, and the control method including: 101, obtaining battery data corresponding to each battery; 102, obtaining temperature data corresponding to each battery; 103, determining a risk level of thermal runaway for each battery based on the battery data and/or the temperature data; 104, if it is detected that the risk level is less than the preset thermal diffusion level, sending an early warning signal corresponding to the risk level; and 105, if it is detected that the risk level is greater than or equal to the preset thermal diffusion level, performing a fire extinguishing control processing on the battery with the risk level greater than or equal to the preset thermal diffusion level, to prevent the thermal diffusion from occurring.

In some embodiment, the BMS master board in the battery pack obtains the battery data corresponding to each battery, obtains the temperature data corresponding to each battery, determines the risk level of the thermal runaway for each battery based on the battery data and/or the temperature data, sends an early warning signal corresponding to the risk level if it is detected that the risk level is less than the preset thermal diffusion level, and performs the fire extinguishing control processing on the battery with the risk level greater than or equal to the preset thermal diffusion level if it is detected that the risk level is greater than or equal to the preset thermal diffusion level, to prevent the thermal diffusion. In the present embodiment, the data related to the battery is obtained, and then the thermal runaway detection is performed according to the data to obtain the thermal runaway detection result (such as a result that the risk level is less than (or greater than or equal to) the preset thermal diffusion level) to ensure accuracy of detection, and then corresponding thermal runaway processing is started according to the thermal runaway detection result to ensure timely and effective thermal runaway early warning control.

The battery data includes a battery voltage, a battery temperature, and a battery temperature rise. The determining of the risk level of the thermal runaway for each battery based on the battery data and/or the temperature data includes: if a battery temperature rise is less than a preset temperature rise threshold value, determining that the risk level of the thermal runaway of the battery corresponding to the battery temperature rise is less than the preset thermal diffusion level; if the battery temperature rise is greater than or equal to the preset temperature rise threshold value and at least one of the battery voltage and the battery temperature does not satisfy the corresponding threshold value, determining that the risk level of the thermal runaway of the corresponding battery is greater than or equal to the preset thermal diffusion level; and if the battery temperature rise is greater than or equal to the preset temperature rise threshold value, and at least one of the battery voltage and the battery temperature data satisfies the corresponding threshold value, determining that the risk level of the thermal runaway of the corresponding battery is greater than or equal to the preset thermal diffusion level.

The battery data includes the battery voltage, the battery temperature, and the battery temperature rise. The battery voltage, the battery temperature, and the battery temperature rise respectively correspond to threshold values for determining the risk level of the thermal runaway. For example, a preset temperature rise threshold value corresponding to the battery temperature rise is 1°C/s, and a threshold value corresponding to the battery temperature rise is 75 °C.

In some embodiments, when the battery temperature rise is less than a preset temperature rise threshold value, it is determined that the risk level of the thermal runaway of the battery corresponding to the battery temperature rise is less than the preset thermal diffusion level. That is, when the battery temperature rise does not meet a condition where the thermal runaway occurs, it indicates that the probability of the thermal runaway for the corresponding battery is lower, and an early warning signal may be sent in this case. When the battery temperature rise is greater than or equal to the preset temperature rise threshold value at least one of the battery voltage and the battery temperature does not satisfy the threshold value corresponding to the at least one of the battery voltage and the battery temperature; or when the battery temperature rise is greater than or equal to the preset temperature rise threshold value and at least one of the battery voltage and the temperature data does not satisfy the threshold value corresponding to the at least one of the battery voltage and the battery temperature, it is determined that the risk level of the thermal runaway for the corresponding battery is greater than or equal to the preset thermal diffusion level, so that accurate and comprehensive detection of the thermal runaway for the battery may be realized, and the accuracy of detection may be ensured.

The thermal runaway early warning control method of the battery pack further includes: obtaining at least one of the smoke amount, the temperature data, and the gas concentration for the battery pack; detecting whether any one of the smoke amount, the temperature data, and the gas concentration is abnormal; if abnormal, performing a fire extinguishing control processing on the battery pack.

In some embodiments, at least one of the smoke amount, the temperature data, and the gas concentration of the battery pack is obtained, and it is detected whether any one of the smoke amount, the temperature data, and the gas concentration is abnormal. If at least one of the smoke amount, the temperature data, and the gas concentration is abnormal, it indicates that the battery pack is at risk of the thermal runaway. In this case, the fire extinguishing control processing is performed on the battery pack, so that real-time monitoring and timely processing of the thermal runaway for the battery pack are realized.

The thermal runaway early warning control method of the battery pack further includes: collecting the temperature data of each battery in the battery pack; and performing temperature check on the temperature data and the battery temperature.

In some embodiments, the temperature data of each battery in the battery pack is collected, and the temperature check is performed on the temperature data and the battery temperature, so that misjudgment of the temperature may be avoided, and the accuracy of the subsequent thermal runaway detection may be improved.

As shown in FIG. 4, some embodiments of the present application further provide a thermal runaway early warning control device 200 for a battery pack. The thermal runaway early warning control device 200 for the battery pack includes a first obtaining module 201, a second obtaining module 202, a determining module 203, an early warning module 204, and the control module 205.

The first obtaining module 201 is configured to obtain battery data corresponding to each battery;

The second obtaining module 202 is configured to obtain temperature data corresponding to each battery;

The determining module 203 is configured to determine a risk level of thermal runaway of each battery according to the battery data and/or the temperature data;

The early warning module 204 is configured to send an early warning signal corresponding to the risk level if it is detected that the risk level is less than the preset thermal diffusion level;

The control module 205 is configured to perform a fire extinguishing control processing on the battery with the risk level greater than or equal to the preset thermal diffusion level, to prevent the thermal diffusion from occurring, if it is detected that the risk level is greater than or equal to the preset thermal diffusion level.

In some embodiments, the determining module 203 is configured to:
if a battery temperature rise is less than a preset temperature rise threshold value, determine that the risk level of the thermal runaway of the battery corresponding to the battery temperature rise is less than the preset thermal diffusion level;
if the battery temperature rise is greater than or equal to the preset temperature rise threshold value and at least one of the battery voltage and the battery temperature does not satisfy the corresponding threshold value, determine that the risk level of the thermal runaway of the battery corresponding to the battery temperature rise and the at least one of the battery voltage and the battery temperature is greater than or equal to the preset thermal diffusion level; and
if the battery temperature rise is greater than or equal to the preset temperature rise threshold value, and at least one of the battery voltage and the battery temperature data satisfies the corresponding threshold value, determine that the risk level of the thermal runaway of the corresponding battery is greater than or equal to the preset thermal diffusion level.

In some embodiments, the thermal runaway early warning control device for the battery pack further includes: a third obtaining module, configured to obtain at least one of the smoke amount, the temperature data, and the gas concentration for the battery pack; a detection module, configured to detect whether any one of the smoke amount, the temperature data, and the gas concentration is abnormal; and a processing module configured to perform the fire extinguishing control processing on the battery pack if abnormality.

In some embodiments, the thermal runaway early warning control device for the battery pack further includes: a collection module, configured to collect the temperature data of each battery in the battery pack; and a check module, configured to perform temperature check on the temperature data and the battery temperature.

Some embodiments of the present application further provide an electronic device that integrates the thermal runaway early warning control device for the battery pack according to any one of the embodiments of the present application. The electronic device includes: one or more processors; a memory; and one or more applications, where the one or more applications are stored in memory and configured to perform, by the processor, the thermal runaway early warning control method for the battery pack in any of the thermal runaway early warning control methods for the battery pack according to the embodiments of the present application.

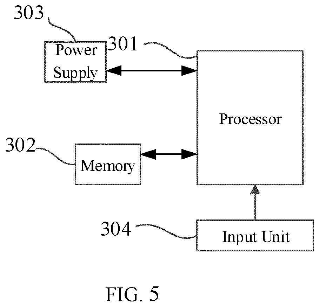

Some embodiments of the present application further provide an electronic device that integrates any of the thermal runaway early warning control devices for the battery pack according to the embodiments of the present application. FIG. 5 is a schematic block diagram of an electronic device according to some embodiments of the present application.

The electronic device may include components such as a processor 301 of one or more processing batteries, a memory 302 of one or more computer-readable storage media, a power supply 303, an input unit 304, and the like. It will be appreciated by those skilled in the art that the configuration of the electronic device shown in FIG. 5 does not tend to limit the electronic device, and may include more or less components than illustrated, or may combine certain components, or have different component arrangements.

The processor 301 is a control center of the electronic device, connects various parts of the entire electronic device by various interfaces and lines, and executes various functions of the electronic device and processes data by running or executing software programs and/or modules stored in the memory 302 and invoking data stored in the memory 302, thereby monitoring the electronic device as a whole. Optionally, the processor 301 may include one or more processing batteries. For example, the processor 301 may integrate an application processor and a modem processor, where the application processor mainly processes an operating system, a user interface, an application program, and the like, and the modem processor mainly processes wireless communication. It will be appreciated that the modem processor may not be integrated into the processor 301.

The memory 302 may be configured to store software programs and modules, and the processor 301 executes various functional applications and data processing by running the software programs and the modules stored in the memory 302. The memory 302 may mainly include a storage program area and a storage data area. The storage program area may store an operating system, an application program (such as a sound play function, an image play function, and the like) required by at least one function, and the like. The storage data area may store data or the like created according to use of the electronic device. In addition, the memory 302 may include a high speed random access memory, and may further include a non-volatile memory, such as at least one magnetic disk storage device, a flash memory device, or other volatile solid state storage devices. Accordingly, the memory 302 may further include a memory controller to provide access to the memory 302 by the processor 301.

The electronic device further includes a power supply 303 for supplying power to the respective components. For example, the power supply 303 may be logically connected to the processor 301 through a power management system, so that the power management system may realize functions such as charging, discharging, and power consumption management. The power supply 303 may further include any other component such as one or more DC or AC power supplies, a recharging system, a power failure detection circuit, a power converter or an inverter, a power status indicator, or the like.

The electronic device may further include an input unit 304 configured to receive input numeric or character information and to generate input signal of keyboard, mouse, joystick, optical or trackball related to user settings and functional control.

Although not shown, the electronic device may further include a display unit or the like, and details are not described herein. Specifically, in the present embodiment, the processor 301 in the electronic device loads the executable files corresponding to the processes of one or more application programs into the memory 302 according to the following instructions, and the processor 301 runs the application programs stored in the memory 302, thereby implementing various functions, as follows:
obtaining battery data corresponding to each battery;
obtaining temperature data corresponding to each battery;
determining a risk level of thermal runaway for each battery based on the battery data and/or the temperature data;
if it is detected that the risk level is less than the preset thermal diffusion level, sending an early warning signal corresponding to the risk level; and
if it is detected that the risk level is greater than or equal to the preset thermal diffusion level, performing a fire extinguishing control processing on the battery with the risk level greater than or equal to the preset thermal diffusion level, to prevent the thermal diffusion.

It will be appreciated by those of ordinary skill in the art that all or a portion of the steps of any one of the various methods according to the above-described embodiments may be performed by instructions, which may be stored in a computer-readable storage medium and loaded and executed by a processor, or by the associated hardware controlled by the instructions.

To this end, embodiments of the present application provide a computer-readable storage medium that may be non-volatile or volatile. The computer-readable storage medium may include a read-only memory (ROM), a random access memory (RAM), a magnetic disk, an optical disk, or the like. A computer program is stored on the computer-readable storage medium, and the computer program is loaded by a processor to perform steps in the thermal runaway early warning control method of the battery pack according to some embodiments of the present application. For example, the computer program loaded by a processor may perform the following steps:
obtaining battery data corresponding to each battery;
obtaining temperature data corresponding to each battery;
determining a risk level of thermal runaway for each battery based on the battery data and/or the temperature data;
if it is detected that the risk level is less than the preset thermal diffusion level, sending an early warning signal corresponding to the risk level; and
if it is detected that the risk level is greater than or equal to the preset thermal diffusion level, performing a fire extinguishing control processing on the battery with the risk level greater than or equal to the preset thermal diffusion level, to prevent the thermal diffusion.

## Claims

1. A battery pack, **characterized in that** the battery pack includes a plurality of batteries, a BMS slave board, a battery management system (BMS) master board, a high-temperature detection module, and a fire extinguishing module, wherein the BMS slave board, the high-temperature detection module, and the fire extinguishing module are respectively communicatively connected to the BMS master board;
the BMS slave board is communicatively connected to each of the plurality of batteries, and is configured to collect battery data corresponding to each of the plurality of batteries and send the battery data to the BMS master board;
the high-temperature detection module is connected to each of the plurality of batteries and is configured to collect temperature data corresponding to each of the plurality of batteries and send the temperature data to the BMS master board; and
the fire extinguishing module is configured to prevent thermal diffusion from occurring in the battery in response to a start instruction sent by the BMS master board.

2. The battery pack according to claim 1, **characterized in that** each of the plurality of batteries is provided with a corresponding one of signal points, and a corresponding one of signal lines is led from each of the signal points; and
the BMS slave board is connected to the signal line through a wiring harness, and is configured to collect the battery data of the battery corresponding to the signal line.

3. The battery pack according to claim 2, **characterized in that** the high-temperature detection module is connected to the signal line through the wiring harness and is configured to collect the temperature data of the battery corresponding to the signal line.

4. The battery pack according to claim 1, **characterized in that** the battery pack further includes a fire detection module communicatively connected with the fire extinguishing module, the fire detection module includes at least one of a smoke detector, a smoke detector, and a temperature sensor; and
the fire detection module is configured to drive the fire extinguishing module to perform a fire extinguishing function to prevent the battery pack from igniting and exploding.

5. The battery pack according to any one of claims 1 to 4, **characterized in that** the battery pack further includes a thermal insulation sheet disposed between two adjacent ones of the plurality of batteries.

6. The battery pack according to any one of claims 1 to 4, **characterized in that** the battery pack further includes a main circuit power-on control module communicatively connected to the BMS master board.

7. A thermal runaway early warning control method for a battery pack, the battery pack includes a plurality of batteries, and the thermal runaway early warning control method for the battery pack includes:
obtaining battery data corresponding to each of the plurality of batteries (101);
obtaining temperature data corresponding to each of the plurality of batteries (102);
determining a risk level of thermal runaway for each of the plurality of batteries according to the battery data and/or the temperature data (103);
if it is detected that the risk level is less than a preset thermal diffusion level, sending an early warning signal corresponding to the risk level (104); and
if it is detected that the risk level is greater than or equal to the preset thermal diffusion level, performing a fire extinguishing control processing on one of the plurality of batteries with the risk level greater than or equal to the preset thermal diffusion level to prevent the thermal diffusion from occurring (105).

8. The thermal runaway early warning control method for the battery pack according to claim 7, **characterized in that** the battery data includes a battery voltage, a battery temperature, and a battery temperature rise;
the determining of the risk level of the thermal runaway for each of the plurality of batteries based on the battery data and/or the temperature data (103) includes:
if the battery temperature rise is less than a preset temperature rise threshold value, determining that the risk level of the thermal runaway of the battery corresponding to the battery temperature rise is less than the preset thermal diffusion level;
if the battery temperature rise is greater than or equal to the preset temperature rise threshold value and at least one of the battery voltage and the battery temperature does not satisfy a threshold value corresponding to the at least one of the battery voltage and the battery temperature, determining that the risk level of the thermal runaway of the battery corresponding to the battery temperature rise and the at least one of the battery voltage and the battery temperature is greater than or equal to the preset thermal diffusion level; and
if the battery temperature rise is greater than or equal to the preset temperature rise threshold value, and at least one of the battery voltage and the battery temperature data satisfies the threshold value corresponding to the at least one of the battery voltage and the battery temperature, determining that the risk level of the thermal runaway of the battery corresponding to the battery temperature rise and the at least one of the battery voltage and the battery temperature is greater than or equal to the preset thermal diffusion level.

9. The thermal runaway early warning control method for the battery pack according to claim 7, **characterized in that** the thermal runaway early warning control method further includes:
obtaining at least one of smoke amount, temperature data, and a gas concentration for the battery pack;
detecting whether any one of the smoke amount, the temperature data, and the gas concentration is abnormal; and
if abnormal, performing a fire extinguishing control processing on the battery pack.

10. The thermal runaway early warning control method for the battery pack according to claim 8, **characterized in that** the thermal runaway early warning control method further includes:
collecting the temperature data corresponding to each of the plurality of batteries in the battery pack; and
performing temperature check on the temperature data and the battery temperature.

11. A thermal runaway early warning control device (200) for the battery pack according to any of claims 1-6, **characterized in that** the thermal runaway early warning control device includes:
a first obtaining module (201), configured to obtain battery data corresponding to each of the plurality of batteries;
a second obtaining module (202), configured to obtain temperature data corresponding to each of the plurality of batteries;
a determining module (203), configured to determine a risk level of thermal runaway of each of the plurality of batteries according to the battery data and/or the temperature data;
an early warning module (204), configured to, if it is detected that the risk level is less than the preset thermal diffusion level, send an early warning signal corresponding to the risk level; and
a control module (205), configured to, if it is detected that the risk level is greater than or equal to the preset thermal diffusion level, perform a fire extinguishing control processing on one of the plurality of batteries with the risk level greater than or equal to the preset thermal diffusion level, to prevent the thermal diffusion from occurring.

12. The thermal runaway early warning control device (200) for the battery pack according to claim 11, **characterized in that** the battery data includes a battery voltage, a battery temperature, and a battery temperature rise, and the determining module (203) is configured to:
if the battery temperature rise is less than a preset temperature rise threshold value, determine that the risk level of the thermal runaway of the battery corresponding to the battery temperature rise is less than the preset thermal diffusion level;
if the battery temperature rise is greater than or equal to the preset temperature rise threshold value and at least one of the battery voltage and the battery temperature does not satisfy a threshold value corresponding to the at least one of the battery voltage and the battery temperature, determine that the risk level of the thermal runaway of the battery corresponding to the battery temperature rise and the at least one of the battery voltage and the battery temperature is greater than or equal to the preset thermal diffusion level; and
if the battery temperature rise is greater than or equal to the preset temperature rise threshold value, and at least one of the battery voltage and the battery temperature data satisfies the threshold value corresponding to the at least one of the battery voltage and the battery temperature, determine that the risk level of the thermal runaway of the battery corresponding to the battery temperature rise and the at least one of the battery voltage and the battery temperature is greater than or equal to the preset thermal diffusion level, and
wherein the thermal runaway early warning control device (200) further includes:
a collection module, configured to collect the temperature data corresponding to each of the plurality of batteries in the battery pack; and
a check module, configured to perform temperature check on the temperature data and the battery temperature.

13. The thermal runaway early warning control device (200) for the battery pack according to claim 11, **characterized in that** the thermal runaway early warning control device further includes:
a third obtaining module, configured to obtain at least one of smoke amount, temperature data, and gas concentration for the battery pack;
a detection module, configured to detect whether any one of the smoke amount, the temperature data, and the gas concentration is abnormal;
a processing module configured to perform the fire extinguishing control processing on the battery pack if abnormality.

14. An electronic device, **characterized in that** the electronic device includes:
one or more processors (301); and
a storage device (302) configured to store one or more programs,
wherein the one or more programs, when executed by the one or more processors (301), allow the one or more processors (301) to implement the thermal runaway early warning control method for the battery pack according to any one of claims 7 to 10.

15. A storage medium **characterized in that** the storage medium includes computer-executable instructions, when executed by a computer processor (301), are configured to perform the thermal runaway early warning control method for the battery pack according to any one of claims 7 to 10.
